# EUROPÄISCHE PATENTSCHRIFT

(11) **EP 2 744 318 B1**
(45) Veröffentlichungstag und Bekanntmachung des Hinweises auf die Patenterteilung: **08.09.2021**
(21) Anmeldenummer: 13196840.6
(22) Anmeldetag: 12.12.2013
(51) Int. Cl.: F21V 23/00, F21V 29/508, F21V 23/02, H02K 5/00, F21V 15/01, H05K 7/20, H05B 41/02, H05B 41/28

(54) **Gehäuse zur Aufnahme elektrischer oder elektronischer Komponenten**
Housing for electrical or electronic components
Boîtier destiné au logement de composants électriques ou électroniques

(30) Priorität: 12.12.2012 DE 202012104830 U
(43) Veröffentlichungstag der Anmeldung: 18.06.2014
(73) Patentinhaber: Zumtobel Lighting GmbH, 6850 Dornbirn (AT)
(72) Erfinder: Favarolo, Herr Piere Angelo, 88239 Wangen (DE)
(74) Vertreter: Thun, Clemens

(56) Entgegenhaltungen:
- EP-A1- 0 955 711
- EP-A2- 1 811 624
- DE-A1-102008 053 779
- DE-A1-102010 039 012
- DE-U- 7 048 119
- US-A- 2 924 702
- US-A- 3 673 402
- US-A- 5 624 178
- US-A- 5 908 235
- US-A- 5 942 727

## Beschreibung

Die vorliegende Erfindung betrifft ein elektronisches Vorschaltgerät (EVG) oder einen Konverter, aufweisend ein Gehäuse, welches zur Aufnahme elektrischer oder elektronischer Komponenten vorgesehen ist, wobei die elektrischen oder elektronischen Komponenten für den Betrieb oder die Steuerung von Lichtquellen vorgesehen sind.

Bei Geräten mit elektronischen Komponenten, mit deren Hilfe bspw. Lichtquellen mit Strom versorgt werden, ist immer auch die während des Betriebs entstehende Wärme zu berücksichtigen. Üblicherweise werden von den Herstellern der elektronischen Komponenten bestimmte Temperaturbereiche angegeben, innerhalb derer die Komponenten betrieben werden sollen. Liegt stattdessen die Betriebstemperatur unterhalb oder oberhalb des vorgegebenen Bereichs, kann ein fehlerfreier Betrieb nicht mehr gewährleistet werden. Ein Problem stellt dabei insbesondere die während des Betriebs auftretende Wärme dar, die zu Überhitzungen und Beschädigungen der Komponenten führen kann.

Es hat sich in diesem Zusammenhang herausgestellt, dass insbesondere auch die Gestaltung des Gehäuses, in dem die elektronischen Komponenten angeordnet werden, eine zentrale Rolle für die Wärmeregulierung spielt. Über die aus Metall bestehenden Gehäusewände kann die Wärme verhältnismäßig gut an die Umgebung abgeführt werden. Voraussetzung hierfür ist allerdings, dass zunächst die von den elektronischen Komponenten erzeugte Wärme effektiv auf die Gehäusewände übertragen wird. Dies kann zwar durch zusätzliche Maßnahmen wie thermisch leitfähige Pads oder dergleichen verbessert werden, letztendlich kann eine effektive Wärmeübertragung allerdings nur dann stattfinden, wenn sich eine wärmeerzeugende Komponente in der Nähe einer Gehäusewand befindet. D.h., das Gehäuse sollte hinsichtlich seiner Abmessungen derart an die darin befindliche Elektronik angepasst werden, dass sich diese - bzw. zumindest diejenigen Komponenten, die Wärme erzeugen - möglichst nahe an einer Gehäusewand befindet.

In der Praxis bedeutet dies, dass je nach Ausgestaltung der Elektronik des entsprechenden Geräts das Gehäuse angepasst werden sollte bzw. die Elektronik in spezieller Weise ausgestaltet werden sollte, um optimal in das Gehäuse eingefügt werden zu können. Da die elektronischen bzw. elektrischen Komponenten sehr unterschiedlich ausgebildet sein können, je nachdem, welche Art von Lichtquellen betrieben werden sollen, bedeutet dies, dass für jeden Gerätetyp ein spezielles Gehäuse zur Verfügung gestellt werden müsste.

Aus der US 5,942,727 ist ein Vorschaltgerät mit allen Merkmalen des Oberbegriffs des unabhängigen Anspruchs bekannt.

Aus der US 5,908,235 ist ein Vorschaltgerät für Leuchtstoffröhren bekannt. Das Gerät umfasst ein Gehäuse mit einem Basisteil und einer Abdeckung.

Aus der DE 10 2008 053 779 A1 ist eine Bodeneinbaukassette für elektrische Installationsgeräte bekannt. Die Kassette umfasst ein Oberteil, das sich gegenüber einem Unterteil teleskopartig einschieben und ausziehen lässt. Eine weitere Bodeneinbaukassette zeigt die Schrift EP 1 811 624 A2.

Aus der EP 0 955 711 A1 ist ein Schrank für die Montage elektrischer oder elektronischer Elemente oder Baugruppen bekannt. Die Tiefe des Schranks lässt sich durch unterschiedliche gegenseitige Positionierung zweier Schrankschalen einstellen. Aus der DE 70 48 119 U ist ein Unterputz-Abzweigkasten bekannt, bei dem mit Hilfe eines verschiebbar gestalteten Mantelkörpers ein Abschlussdeckel so eingestellt werden kann, dass er bündig mit der verputzen Wand abschließt.

Aus der US 5 624 178 A, der US 2 924 702 A und der US 3 673 402 A sind Leuchtengehäuse bekannt, welche aus zwei oder mehr Gehäuseteilen bestehen und durch unterschiedliche Positionen der Gehäuseteile zueinander in variabler Länge fixiert werden können.

Der vorliegenden Erfindung liegt die Aufgabenstellung zugrunde, die oben beschriebenen Probleme zu vermeiden.

Die Aufgabe wird durch ein elektronisches Vorschaltgerät oder Konverter zum Ansteuern und/oder Betreiben von Lichtquellen mit einem Gehäuse zur Aufnahme elektrischer oder elektronischer Komponenten mit den Merkmalen des Anspruchs 1 gelöst. Vorteilhafte Weiterbildungen der Erfindung sind Gegenstand der abhängigen Ansprüche.

Kerngedanke der vorliegenden Erfindung ist es, ein elektronisches Vorschaltgerät oder Konverter mit einem Gehäuse zur Verfügung zu stellen, welches in einfacher Weise hinsichtlich seiner Höhe an die in dem Gehäuse anzuordnende Elektronik angepasst werden kann. Die erfindungsgemäße

Lösung sieht hierzu vor, dass das Gehäuse aus zwei Gehäuseteilen besteht, welche in verschiedenen, zumindest jedoch in zwei verschiedenen Konfigurationen miteinander verbindbar sind, um das Gehäuse zu bilden. Die verschiedenen Konfigurationen unterscheiden sich dabei dadurch, dass der Innenraum des Gehäuses unterschiedliche Abmessungen aufweist.

Gemäß der vorliegenden Erfindung wird deshalb ein elektronisches Vorschaltgerät oder Konverter, aufweisend ein Gehäuse und darin angeordnet eine Platine, auf welcher elektrische und/oder elektronische Komponenten für den Betrieb oder die Steuerung von Lichtquellen angeordnet sind, wobei an den beiden Stirnseiten des Gehäuses Fortsätze angeordnet sind, vorgeschlagen, wobei das Gehäuse aus einem unteren Gehäuseteil und einem oberen Gehäuseteil besteht, und die Platine in dem unteren Gehäuseteil parallel zur unteren Wand des unteren Gehäuseteils angeordnet ist, wobei die zwei Gehäuseteile teleskopartig ineinander greifen und im zusammengefügten Zustand ein geschlossenes Gehäuse bilden, wobei die beiden Gehäuseteile in unterschiedlichen Höhen fest miteinander verbindbar sind, so dass die Höhe zwischen der oberen Wand des oberen Gehäuseteils und der unteren Wand des unteren Gehäuseteils variierbar bzw. einstellbar ist und der Innenraum des Gehäuses unterschiedliche Abmessungen aufweist.

Dadurch, dass das Gehäuse nunmehr erfindungsgemäß hinsichtlich seiner Abmessungen variiert werden kann, besteht die Möglichkeit, dieses Gehäuse für unterschiedliche Elektroniken zu verwenden. Die Abmessungen des Gehäuses werden also in einfacher Weise an die darin befindliche Elektronik angepasst, wobei jederzeit gewährleistet ist, dass eine gute Wärmeübertragung von den entsprechenden Elementen der Elektronik auf die Gehäusewände erzielt wird. Damit kann das Gehäuse für unterschiedliche Gerätetypen verwendet werden, wobei trotz allem grundsätzlich die erforderliche Ableitung der während des Betriebs auftretenden Wärme gewährleistet ist.

Erfindungsgemäß wird das Gehäuse durch Gehäuseteile gebildet, welche teleskopartig ineinander greifen. Hierdurch kann der Abstand zwischen zwei gegenüberliegenden Seitenwänden des Gehäuses variiert werden, wobei es sich bei diesen Wänden um die beiden Flachseiten handelt. Es wird also die Bauhöhe des Gehäuses an die darin befindliche Elektronik angepasst, wobei sowohl eine stufenlose Verstellung als auch eine Verstellung in definierten Schritten denkbar wäre. Eine stufenlose Verstellung kann bspw. dadurch erzielt werden, dass die Gehäuseteile über eine Schraubverbindung miteinander verbunden sind. Auch der Einsatz geeigneter Rastelemente wäre denkbar, um in mehreren Stufen eine Anpassung der Abmessungen des Gehäuses vorzunehmen.

Vorzugsweise bestehen die Gehäuseteile aus Metall, um eine gute Übertragung der Wärme an die Umgebungsluft erzielen zu können. Zumindest eines der Gehäuseteile könnte allerdings ggf. auch aus Kunststoff oder dergleichen bestehen.

Nachfolgend soll die Erfindung anhand der beiliegenden Zeichnung näher erläutert werden. Es zeigen:
- Figur 1: eine perspektivische Ansicht eines erfindungsgemäßen Gehäuses eines elektronischen Vorschaltgeräts oder Konverters zur Aufnahme elektronischer bzw. elektrischer Komponenten;
- Figur 2: eine Schnittdarstellung des Gehäuses von Figur 1 und
- Figur 3: eine weitere Variante eines erfindungsgemäßen Gehäuses in seitlicher Schnittdarstellung.

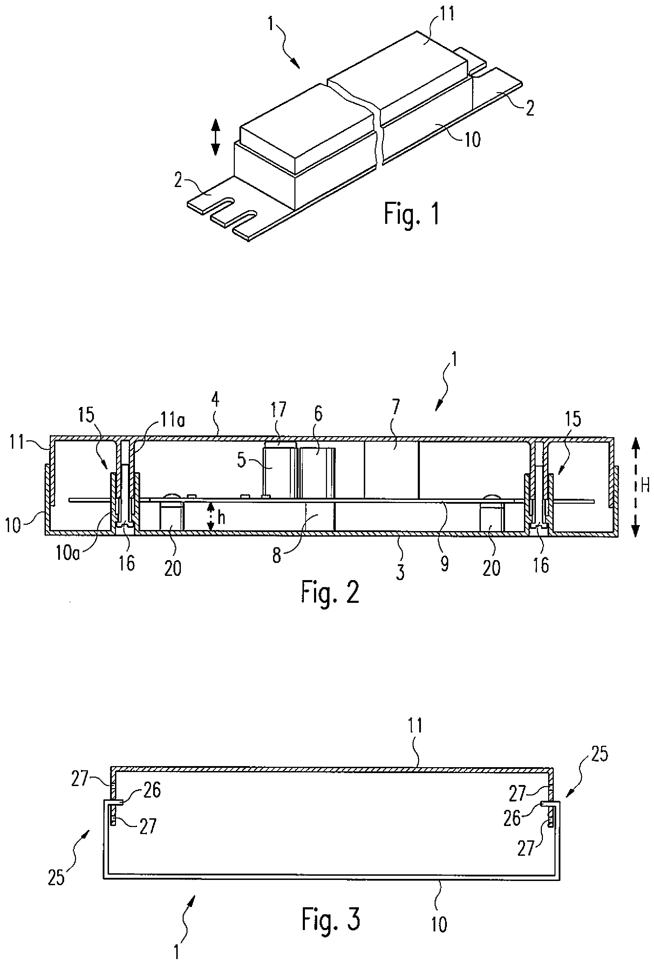

Das in Figur 1 dargestellte und mit dem Bezugszeichen 1 versehene erfindungsgemäße Gehäuse weist die typische Form eines Gehäuses eines elektronischen Vorschaltgeräts (EVG) auf, über das z.B. Leuchtstofflampen mit Strom versorgt werden. Das Gehäuse 1 ist dementsprechend etwa quaderförmig, länglich ausgebildet, wobei an den beiden Stirnseiten des Gehäuses 1 laschenartige Fortsätze 2 angeordnet sind, über die bspw. eine Befestigung des Gehäuses 1 innerhalb einer Leuchte erfolgt. Die Fortsätze 2 dienen ferner auch der Halterung nicht dargestellter Anschlussklemmen zur Verbindung des Geräts mit den Stromversorgungsleitungen bzw. mit Leitungen zum Verbinden mit den zu betreibenden Lichtquellen.

Wie die seitliche Schnittdarstellung von Figur 2 zeigt, sind im Innenraum des Gehäuses 1 mehrere elektronische Komponenten 5 bis 8 angeordnet. Die Lagerung dieser elektronischen Komponenten 5 bis 8 erfolgt mit Hilfe einer Platine 9, die mittels später noch näher beschriebener Abstandshalter 20 auf einer Bodenfläche 3 des Gehäuses 1 angeordnet ist. Die elektronischen Komponenten 5 bis 8 können dabei sowohl an der Oberseite als auch an der Unterseite der Platine 9 angeordnet sein.

Zumindest einige der elektronischen Komponenten 5 bis 8 erzeugen während des Betriebs des Geräts Wärme, welche möglichst effektiv abgeführt werden sollte, um einen dauerhaften Betrieb innerhalb eines von den Herstellern der Komponenten vorgeschriebenen Temperaturbereichs zu gewährleisten. Das Abführen der Wärme erfolgt in erster Linie über die Gehäusewände, insbesondere über die Unterseite 3 sowie die Oberseite 4 des Gehäuses 1.

Eine wesentliche Voraussetzung für eine effektive Ableitung der Wärme über das Gehäuse 1 ist allerdings, dass sich die Gehäusewände, insbesondere die Wände 3 und 4, in der Nähe der wärmeproduzierenden Elemente befinden. Andernfalls würde die dazwischenliegende Luft, welche eine verhältnismäßig geringe thermische Leitfähigkeit besitzt, als Isolator wirken. Dieser angestrebte geringe Abstand zwischen den Gehäusewänden 3, 4 und den elektronischen Komponenten 5 bis 8 wird nunmehr erfindungsgemäß dadurch erzielt, dass die Höhe H des Gehäuses 1 variierbar bzw. einstellbar ist.

Eine Einstellung der Gehäusehöhe H wird im dargestellten Ausführungsbeispiel dadurch ermöglicht, dass das Gehäuse 1 aus zwei Gehäuseteilen 10, 11 gebildet ist, welche jeweils trog- bzw. topfartig ausgebildet sind und derart teleskopartig ineinander greifen, dass sie im zusammengefügten Zustand ein geschlossenes Gehäuse bilden. Das untere Gehäuseteil 3 weist dabei zusätzlich die beiden in Figur 1 gezeigten seitlichen Fortsätze 2 auf. Das obere Gehäuseteil 4 ist hinsichtlich seiner Abmessungen etwas schmäler ausgeführt, sodass es mit seinen Seitenwänden in das untere Gehäuseteil 3 eingreifen kann.

Die beiden Gehäuseteile 3 und 4 können dabei in den unterschiedlichen Höhen fest miteinander verbindbar sein, so dass die eingestellte Gehäusehöhe H dauerhaft beibehalten wird. Beim dargestellten Ausführungsbeispiel wird dies dadurch erzielt, dass eine Schraubverbindung 15 zwischen den Gehäuseteilen 10, 11 vorgesehen ist. Hierzu weisen beide Gehäuseteile 10, 11 jeweils in den Innenraum des Gehäuses 1 ragende Hülsenabschnitte 10a bzw. 11a auf, sodass mit Hilfe entsprechender Schrauben 16 ein Verbinden der Gehäuseteile 10, 11 erfolgen kann. Je nachdem, wie weit die Schrauben 16 in die Hülsenabschnitte 11a des oberen Gehäuseteils 4 eingeschraubt werden, ergibt sich dann eine bestimmte Höhe H für das Gehäuse 1. Mit Hilfe der dargestellten Schraubverbindungen 15 kann also - innerhalb eines bestimmten Bereichs - eine nahezu stufenlose Verstellung des Abstands zwischen Unterseite 3 und Oberseite 4 bzw. eine Anpassung der Gehäusehöhe H erfolgen. Nachdem also die Platine 9 mit den elektronischen Komponenten 5 bis 8 in dem unteren Gehäuseteil 10 angeordnet wurde, erfolgt das Aufsetzen des oberen Gehäuseteils 11 und das Fixieren mit Hilfe der Schraubverbindungen 15, wobei die Höhe H des Gehäuses 1 soweit reduziert wird, dass ein minimaler Abstand zwischen der Gehäuseoberseite 4 und der höchsten elektronischen Komponente 7 vorliegt. Diese liegt im Prinzip an dieser Gehäusewand 4 an. Bei den anderen Komponenten 5 und 6 mit einer etwas geringeren Höhe kann ggf. zur Überbrückung des verbleibenden Freiraums der Einsatz zusätzlicher thermisch leitfähiger Mittel, bspw. entsprechender Kleber oder sog. thermisch leitfähiger Pads 17 vorgesehen sein, um die thermische Kopplung zwischen elektronischer Komponente 5 und Gehäusewand 4 weiter zu verbessern.

Der Abstand h zwischen der Platine 9 und der Gehäuseunterseite 3 ist derart gewählt, dass sich die an der Unterseite der Platine 9 angeordnete elektronische Komponente 8 wiederum möglichst nahe an dieser Wand 3 befindet. Dies kann dadurch erzielt werden, dass zur Lagerung der Platine 9 Abstandshalter 20 verwendet werden, wobei je nach Bauhöhe der Komponente 8 Abstandshalter 20 entsprechender Höhe ausgewählt werden. Auch in diesem Fall befinden sich also entsprechende Komponenten sehr nahe an einer Gehäusewand und es können ergänzend thermisch leitfähige Mittel eingesetzt werden, um die Wärmeübertragung weiter zu optimieren.

Unabhängig von der Art, Anzahl und Anordnung der elektronischen Komponenten innerhalb des Gehäuses 1 ist also durch die erfindungsgemäße Lösung sichergestellt, dass sich diese Komponenten sehr nahe an den Gehäusewänden befinden und dementsprechend eine Ableitung der Wärme verbessert ist. Das erfindungsgemäß ausgestaltete Gehäuse 1 kann also zur Aufnahme unterschiedlichster Elektroniken vorgesehen sein und dementsprechend generell als Elektronikgehäuse für verschiedenste Vorschaltgeräte oder Konverter zum Einsatz kommen. Ein individuelles Anpassen der Bauform des Gehäuses 1 an die Elektronik ist bei der erfindungsgemäßen Lösung nicht mehr erforderlich.

Zum effektiven Ableiten der Wärme über die Gehäusewände bestehen die beiden Gehäuseteile selbstverständlich verzugsweise aus einem Material hoher thermischer Leitfähigkeit, wobei sich insbesondere der Einsatz von Metall anbietet. Es wäre allerdings auch denkbar, zumindest eines der Gehäuseteile aus einem anderen Material, z.B. aus Kunststoff oder dergleichen zu bilden.

Eine alternative Möglichkeit zur Einstellbarkeit der Höhe des Gehäuses 1 ist in Figur 3 dargestellt. Anstelle einer Schraubverbindung ist im vorliegenden Fall eine Rastverbindung 25 zwischen Gehäuseunterteil 10 und Gehäuseoberteil 11 vorgesehen. Diese kann bspw. dadurch erzielt werden, dass die einander gegenüberliegenden Stirnwände des unteren Gehäuseteils 10 nach innen ragende Vorsprünge 26 aufweisen. Die entsprechenden Seitenwände des oberen Gehäuseteils 11 sind dann mit Öffnungen 27 versehen, in welche diese Vorsprünge 26 eingreifen. Dabei sind über die Höhe der Seitenwände hinweg mehrere Öffnungen 27 verteilt ausgebildet, die jeweils zu einer bestimmten Bauhöhe des Gehäuses 1 führen. Je nachdem welche Rastposition gewählt wird, kann also wiederum die Höhe des Gehäuses 1 an die darin befindlichen, in Figur 3 nicht dargestellten elektronischen Komponenten angepasst werden.

Letztendlich wird also mit der erfindungsgemäßen Lösung eine sehr elegante Möglichkeit geschaffen, ein Gehäuse eines elektronischen Vorschaltgeräts oder Konverters in einfacher Weise derart auszugestalten, dass eine optimierte Ableitung der Wärme erzielt wird. Aufwendige Anpassungen des Gehäuses an die jeweilige Elektronik sind dementsprechend bei der vorliegenden Lösung nicht mehr erforderlich.

## Patentansprüche

1. Elektronisches Vorschaltgerät oder Konverter zum Ansteuern und/oder Betreiben von Lichtquellen, aufweisend ein Gehäuse (1) und darin angeordnet eine Platine (9), auf welcher elektrische und/oder elektronische Komponenten (5-8) für den Betrieb oder die Steuerung von Lichtquellen angeordnet sind, wobei an den beiden Stirnseiten des Gehäuses Fortsätze (2) angeordnet sind, wobei das Gehäuse (1) aus einem unteren Gehäuseteil (10) und einem oberen Gehäuseteil (11) besteht, und die Platine in dem unteren Gehäuseteil (10) parallel zur unteren Wand (3) des unteren Gehäuseteils (10) angeordnet ist, wobei die zwei Gehäuseteile teleskopartig ineinander greifen und im zusammengefügten Zustand ein geschlossenes Gehäuse bilden,
**dadurch gekennzeichnet,**
**dass** die beiden Gehäuseteile (10, 11) in unterschiedlichen Höhen fest miteinander verbindbar sind, so dass die Höhe (H) zwischen der oberen Wand (4) des oberen Gehäuseteils (11) und der unteren Wand (3) des unteren Gehäuseteils (10) variierbar bzw. einstellbar ist und der Innenraum des Gehäuses unterschiedliche Abmessungen aufweist.

2. Elektronisches Vorschaltgerät oder Konverter nach Anspruch 1, **dadurch gekennzeichnet,**
**dass** die Gehäuseteile (10, 11) im Wesentlichen stufenlos gegeneinander verstellbar sind.

3. Elektronisches Vorschaltgerät oder Konverter nach einem der vorherigen Ansprüche,
**dadurch gekennzeichnet,**
**dass** die Gehäuseteile (10, 11) über ein oder mehrere Schraubverbindungen (15) miteinander verbunden sind.

4. Elektronisches Vorschaltgerät oder Konverter nach einem der Ansprüche 1 oder 2,
**dadurch gekennzeichnet,**
**dass** die Gehäuseteile (10, 11) über Rastverbindungen (25) miteinander verbunden sind.

5. Elektronisches Vorschaltgerät oder Konverter nach einem der vorherigen Ansprüche,
**dadurch gekennzeichnet,**
**dass** zumindest eines der Gehäuseteile (10, 11), vorzugsweise beide, aus Metall besteht bzw. bestehen.

6. Elektronisches Vorschaltgerät oder Konverter nach einem der vorhergehenden Ansprüche,
**dadurch gekennzeichnet,**
**dass** zwischen zumindest einigen der elektrischen und/oder elektronischen Komponenten (5-8) und einer Wand (3, 4) des Gehäuses (1) ein thermisch leitfähiger Kleber oder thermisch leitfähige Elemente (17) angeordnet sind.

## Claims

1. An electronic ballast or converter for controlling and/or operating light sources, comprising a housing (1) and a board (9), which is arranged therein and on which electrical and/or electronic components (5-8) for operation or control of light sources are arranged, wherein projections (2) are arranged on the two end faces of the housing, wherein the housing (1) consists of a lower housing part (10) and an upper housing part (11), and the board is arranged in the lower housing part (10) parallel to the lower wall (3) of the lower housing part (10), wherein the two housing parts mesh telescopically with one another and in the assembled state form a closed housing,
**characterized in that**
the two housing parts (10, 11) can be fixedly connected to one another at different heights so that the height (H) between the upper wall (4) of the upper housing part (11) and the lower wall (3) of the lower housing part (10) can be varied or adjusted and the internal space of the housing has different dimensions.

2. The electronic ballast or converter according to Claim 1,
**characterized in that**
the housing parts (10, 11) are substantially continuously variable in relation to one another.

3. The electronic ballast or converter according to any one of the preceding claims,
**characterized in that**
the housing parts (10, 11) are connected to one another via one or more screw connections (15).

4. The electronic ballast or converter according to any one of Claims 1 or 2,
**characterized in that**
the housing parts (10, 11) are connected to one another via latching connections (25).

5. The electronic ballast or converter according to any one of the preceding claims,
**characterized in that**
at least one of the housing parts (10, 11), preferably both, consist(s) of metal.

6. The electronic ballast or converter according to any one of the previous claims,
**characterized in that**
a thermally conductive adhesive or thermally conductive elements (17) are arranged between at least some of the electrical and/or electronic components (5-8) and a wall (3, 4) of the housing (1).

## Revendications

1. Ballast électronique ou convertisseur pour la commande et/ou l'exploitation de sources lumineuses, présentant un boîtier (1) dans lequel est disposée une platine (9) sur laquelle sont disposés des composants électriques et/ou électroniques (5-8) permettant l'exploitation ou la commande de sources lumineuses, des prolongements (2) étant disposés sur les deux faces frontales du boîtier, le boîtier (1) étant constitué d'une partie de boîtier inférieure (10) et d'une partie de boîtier supérieure (11) et la platine étant disposée dans la partie de boîtier inférieure (10) parallèlement à la paroi inférieure (3) de la partie de boîtier inférieure (10), les deux parties de boîtier s'emboîtant l'une dans l'autre de manière télescopique et formant un boîtier fermé à l'état assemblé,
**caractérisé en ce que**
les deux parties de boîtier (10, 11) peuvent être fixées l'une à l'autre à des hauteurs différentes, de façon que la hauteur (H) entre la paroi supérieure (4) de la partie de boîtier supérieure (11) et la paroi inférieure (3) de la partie de boîtier inférieure (10) puisse varier ou être ajustée et que l'espace intérieur du boîtier présente des dimensions différentes.

2. Ballast électronique ou convertisseur selon la revendication 1,
**caractérisé en ce que**
les parties de boîtier (10, 11) peuvent être réglées l'une par rapport à l'autre de manière sensiblement continue.

3. Ballast électronique ou convertisseur selon l'une des revendications précédentes,
**caractérisé en ce que**
les éléments de boîtier (10, 11) sont reliés entre eux par un ou plusieurs raccords vissés (15).

4. Ballast électronique ou convertisseur selon l'une des revendications 1 et 2,
**caractérisé en ce que**
les parties de boîtier (10, 11) sont reliées entre elles par un ou plusieurs encliquetages (25).

5. Ballast électronique ou convertisseur selon l'une des revendications précédentes,
**caractérisé en ce que**
au moins une des parties de boîtier (10, 11), et de préférence les deux, sont en métal.

6. Ballast électronique ou convertisseur selon l'une des revendications précédentes,
**caractérisé en ce que**
il est disposé un adhésif thermoconducteur ou des éléments thermoconducteurs (17) entre au moins certains des composants électriques et/ou électroniques (5-8) et une paroi (3, 4) du boîtier (1).
